# EUROPÄISCHE PATENTSCHRIFT

(11) **EP 1 819 477 B1**
(45) Veröffentlichungstag und Bekanntmachung des Hinweises auf die Patenterteilung: **01.06.2011**
(21) Anmeldenummer: 05815662.1
(22) Anmeldetag: 15.11.2005
(51) Int. Cl.: B23K 26/24, B23K 33/00, H01L 23/36, H01L 23/495, H05K 7/20

(54) **VERFAHREN ZUM LASERVERSCHWEISSEN ZWEIER SCHWEISSTEILE MITTELS EINER KEHLNAHT**
METHOD FOR WELDING TWO WELDING PARTS BY MEANS OF A FILLET WELD
PROCEDE POUR LE SOUDAGE AU LASER DE DEUX PIECES A SOUDER AU MOYEN D'UNE SOUDURE D'ANGLE

(30) Priorität: 15.11.2004 DE 102004055083
(43) Veröffentlichungstag der Anmeldung: 22.08.2007
(73) Patentinhaber: TRW Automotive Electronics & Components GmbH & Co. KG, 78315 Radolfzell (DE)
(72) Erfinder: ERTL, Thomas, 78244 Gottmadingen (DE); WILKENDORF, Hardy, 88696 Owingen (DE)
(74) Vertreter: Eder, Thomas
(86) Internationale Anmeldenummer: PCT/DE2005/002054
(87) Internationale Veröffentlichungsnummer: WO 2006/050722

(56) Entgegenhaltungen:
- DE-A1- 19 753 103
- DE-A1- 19 912 443
- US-A- 5 977 511
- PATENT ABSTRACTS OF JAPAN Bd. 2002, Nr. 05, 3. Mai 2002 (2002-05-03) -& JP 2002 018583 A (HITACHI ZOSEN CORP), 22. Januar 2002 (2002-01-22)
- PATENT ABSTRACTS OF JAPAN Bd. 014, Nr. 147 (M-0952), 20. März 1990 (1990-03-20) -& JP 02 011279 A (NIPPON STEEL CORP), 16. Januar 1990 (1990-01-16)
- PATENT ABSTRACTS OF JAPAN Bd. 017, Nr. 064 (M-1364), 8. Februar 1993 (1993-02-08) -& JP 04 270084 A (ISHIKAWAJIMA HARIMA HEAVY IND CO LTD), 25. September 1992 (1992-09-25)

## Beschreibung

Die Erfindung betrifft ein Verfahren zum Verschweißen zweier Schweißteile mittels einer Kehlnaht, insbesondere für das Verschweißen des metallischen Kühlkörpers eines empfindlichen Leistungshalbleiterbauelements mit einem Leiterzug gemäβ dem Oberbegriff das Anspruchs 1 (sich, z.B., DE 197 53 103 A1).

Aus der DE 199 12 443 ist eine elektrische Baueinheit mit wenigstens einem Halbleiterbauelement bekannt, bei der ein beispielsweise als Stanzgitter ausgebildeter Leiterzug mit einem metallischen Kühlkörper eines Leistungshalbleiterbauelements mittels einer Kehlnaht verschweißt wird. Hierdurch wird ein sicherer elektrischer Kontakt erreicht und gleichzeitig das Abführen der Verlustwärme des Leistungshalbleiterbauelements auf den Leiterzug gewährleistet. Da der Kühlkörper eines Leistungshalterbauelements üblicherweise mit einem Anschlusskontakt des Bauelements verbunden ist, ergibt sich zudem der Vorteil, dass der betreffende Anschlusskontakt nicht noch zusätzlich mit dem betreffenden Leiterzug elektrisch verbunden werden muss.

Beim Verschweißen eines Leistungshalbleiterbauelements mit einem Leiterzug ist es erforderlich, durch den Schweißvorgang eine möglichst geringe Wärmemenge auf den Kühlkörper des Leistungshalbleiterbauelements einzubringen, da ansonsten die Gefahr einer Beschädigung oder Zerstörung des auf dem Kühlkörper angeordneten Halbleiterchips besteht.

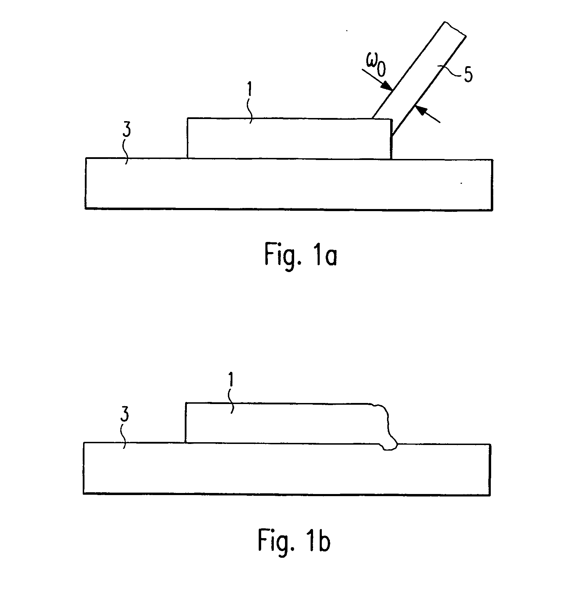

Das von der Anmelderin bisher durchgeführte Schweißverfahren wird nachfolgend zur Erläuterung der damit verbundenen Schwierigkeiten kurz anhand der Darstellungen in den Figuren 1a und 1b näher erläutert.

Wie in Fig. 1a dargestellt, wird ein erstes Schweißteil 1, bei dem es sich beispielsweise um einen Leiterzug in Form eines Stanzgitters handeln kann, mit seiner Unterseite mit der Oberseite eines zweiten Schweißteils 3 in Kontakt gebracht. Bei dem zweiten Schweißteil kann es sich beispielsweise um den metallischen Kühlkörper eines Leistungshalbleiterbauelements handeln.

Das Verschweißen soll beispielsweise durch Laserschweißen am rechten Rand des ersten Schweißteils 1 erfolgen. Hierzu wird die Schweißenergie mittels eines Laserstrahls 5 am Randbereich des ersten Schweißteils in das erste Schweißteil eingebracht. Da es sich bei dem zweiten Schweißteil 3 um den Kühlkörper eines Leistungshalbleiterbauelements handelt, muss dafür Sorge getragen werden, dass die Schweißenergie nur zu einem möglichst geringem Maß in das zweite Schweißteil 3 eingetragen wird, um eine Beschädigung oder Zerstörung des Halbleiterchips zu vermeiden. Demzufolge wird der Laserstrahl in Bezug auf das erste Schweißteil 1 so positioniert, dass der Laserstrahl, der einen der Fleckweite w₀ entsprechenden Durchmesser aufweist, mit seinem gesamten Fleck des Durchmessers w₀ im Bereich der oberen Kante des ersten Schweißteils 1 liegt. Bei Versuchen hat sich herausgestellt, dass der Winkel, den der Laserstrahl mit der Kontaktfläche zwischen dem ersten und zweiten Schweißteil 1, 3 einschließt vorzugsweise im Bereich von 50 bis 80 Grad liegen sollte. Würde der Winkel, den der Laserstrahl 5 mit der Kontaktfläche einschließt, 90 Grad oder mehr betragen, so entstünde nicht die gewünschte Kehlnaht zwischen dem Rand des ersten Schweißteils 1 und der Oberfläche des zweiten Schweißteils 3.

Die fertige Schweißverbindung ist in Figur 1b dargestellt. Der obere Eckbereich bzw. Kantenbereich des ersten Schweißteils ist durch das Eintragen der Schweißenergie mittels des Laserstrahls 5 abgeschmolzen. Da es in diesem Fall nicht erlaubt war, den Laserstrahl direkt in den Eckbereich zwischen dem Rand des ersten Schweißteils 1 und der Oberfläche des zweiten Schweißteils 3 zu richten, musste demzufolge der gesamte obere Rand- bzw. Kantenbereich des ersten Schweißteils 1 abgeschmolzen werden. Die Schweißenergie muss dabei so groß sein und so lange aufrecht erhalten werden, bis nicht nur der gesamte Randbereich des ersten Schweißteils 1 geschmolzen ist, sondern bis auch ein ausreichender Bereich des zweiten Schweißteils 3, der dem aufgeschmolzenen Rand des ersten Schweißteils benachbart ist, mit aufgeschmolzen und mit dem Material des ersten Schweißteils 1 verschmolzen ist.

Das fertige Schweißbild der Kehlnaht ist in Figur 1b dargestellt. Infolge des erforderlichen Abschmelzens der oberen Kante und der möglichst geringen verwendeten Schweißenergie ergibt sich häufig ein optisch wenig ansprechendes Schweißbild, da ein relativ großer Materialfluss erforderlich ist.

Des Weiteren ist die Positionierung der Schweißteile relativ zum Laserstrahl infolge der senkrechten Kante des ersten Schweißteils sehr kritisch. Bereits eine geringfügige Verschiebung des ersten Schweißteils 1 in Figur 1a nach links hätte zur Folge, das der Laserstrahl seine Schweißenergie immer mehr in der Nähe des empfindlichen zweiten Schweißteils 3 oder gar auf diesem selbst einträgt. Dies ist unbedingt zu vermeiden.

Des Weiteren führen geringe Positionsänderungen des ersten Schweißteils 1 relativ zum Laserstrahl 5 zu stark unterschiedlichen Materialflüssen beim Aufschmelzen des Randbereichs des ersten Schweißteils 1. Das Herstellen einer optisch ansprechenden, gleichförmig ausgebildeten Schweißnaht ist daher schwierig.

Aus der DE 196 25 873 A1 ist ein Verfahren zum Verbinden von Fügepartnern bekannt, wonach das Strahlschweißen in seiner Schweißwirkung dadurch verbessert werden kann, dass die äußere Kante eines Schweißteils abgeschrägt ist oder eine Fase aufweist. Das Zuführen des Schweißstrahls erfolgt dabei vorzugsweise unter einem Winkel ungleich 90° zur abgeschrägten oder gefasten Oberfläche, beispielsweise annähernd senkrecht zu dieser Oberfläche in einem bestimmten Abstand zum äußersten Rand dieser Oberfläche. Hierdurch wird eine geringere Empfindlichkeit hinsichtlich der Positionierung des ersten Schweißteils relativ zur Position des Eintragpunkts für die Schweißenergie erreicht.

Ähnliche Verfahren sind auch aus der JP 2002 018583 A und der DE 197 53 103 A1 bekannt, wobei die letztere Schrift zusätzlich ein Verfahren zur einfachen Herstellung einer derart abgeschrägten Kante offenbart. Hierzu wird der äußere Bereich des Schweißteils, welches auf einer ebenen Auflage aufliegt, zunächst unter einem definierten Winkel abgewinkelt, anschließend leicht mit seinem Falz in Richtung einwärts bezogen auf die für das Abwinkeln benutzte Kante der Auflage zurückgezogen und vertikal mit einem geeigneten Werkzeug getrennt. Nach dem anschließenden Zurückbiegen des verbleibenden abgewinkelten Bereichs weist dessen Rand eine Schräge auf, deren Winkel dem Winkel entspricht, um den der Bereich vor dem Trennvorgang abgewinkelt wurde.

Der Erfindung liegt daher ausgehend von diesem Stand der Technik die Aufgabe zugrunde, ein Verfahren zum Verschweißen zweier Schweißteile mittels einer Kehlnaht, insbesondere für das Verschweißen des metallischen Kühlkörpers eines empfindlichen Leistungshalbleiterbauelements mit einem Leiterzug, zu schaffen, wobei das Schweißteil so beschaffen ist und das Verfahren so durchgeführt wird, dass auch das Verschweißen dieses ersten Schweißteils mit einem thermisch empfindlichen zweiten Schweißteil ermöglicht und welches gleichzeitig eine geringere Empfindlichkeit hinsichtlich der Positionierung des ersten Schweißteils relativ zur Position des Eintragpunkts für die Schweißenergie aufweist.

Die Erfindung löst diese Aufgabe mit den Merkmalen des Patentanspruch 1.

Die Erfindung geht von der Erkenntnis aus, dass die Schweißenergie zur Erzeugung einer Kehlnaht zwischen einem ersten und einem zweiten Schweißteil dadurch hergestellt werden kann, dass während des Schweißvorgangs die Schweißenergie ausschließlich einer der Auflagefläche abgewandten Oberfläche des ersten Schweißteils in einem Energiezuführbereich zugeführt wird, welcher vom Rand des ersten Schweißteils einen vorbestimmten Abstand aufweist. Hierdurch ergibt sich eine geringere Positionierempfindlichkeit, da die Schweißenergie nicht mehr, wie in Verbindung mit den Figuren 1a und 1b erläutert, zum Teil an einer vertikalen Seitenfläche des ersten Schweißteils zugeführt wird. Es hat sich überraschenderweise bei Versuchen herausgestellt, dass ein Verschweißen auch noch dann möglich ist, wenn die Energiezufuhr in einem Energiezuführbereich erfolgt, der vom Rand des ersten Schweißteils einen vorbestimmten Abstand aufweist. Abhängig von der Dicke des ersten Schweißteils muss zwar soviel Energie zugeführt werden, bis das gesamte Material in der Dicke des ersten Schweißteils im Bereich des Energiezuführbereichs aufgeschmolzen ist, jedoch kann diese Dicke des ersten Schweißteils im Energiezuführbereich entsprechend gewählt werden. Neben der geringeren Positionierempfindlichkeit wird nach dem erfindungsgemäßen Verfahren der Vorteil erreicht, dass das Material zwischen dem Energiezuführbereich und dem eigentlichen Rand des ersten Schweißteils die Funktion eines Zuführmaterials zur Erzeugung einer vollständigen und guten Schweißnaht übernehmen kann.

Das Zuführen der Schweißenergie erfolgt vorzugsweise in einer Richtung, wobei die Richtungskomponente senkrecht zum Verlauf der herzustellenden Kehlnaht mit der Kontaktebene der Auflageflächen des ersten und zweiten Schweißteils einen Schweißwinkel im Bereich von 50 bis 80 Grad einschließt.

Die Schweißenergie kann beispielsweise mittels eines gepulsten Schweißlasers zugeführt werden. Zum Erzeugen der Schweißnaht vorbestimmter Länge ist es dabei selbstverständlich erforderlich, die Schweißteile relativ zu dem Punkt- bzw. Fleckförmigen Bereich zu verschieben, in dem jeweils der Energieeintrag erfolgt.

Das erste Schweißteil ist in seinem Randbereich, welcher den Energiezuführbereich umfasst, mit einer den Schweißvorgang zur Herstellung der Kehlnaht begünstigenden Struktur versehen.

Nach der Erfindung ist das Schweißteil im Randbereich im Bereich des Energiezuführbereichs oder in einem in Richtung des inneren Bereichs des Schweißteils dem Energiezuführbereich benachbarten Bereich dünner ausgebildet sein als der innere Bereich des ersten Schweißteils. Hierdurch wird erreicht, dass sich ein relativ hoher Wärmeübergangswiderstand zwischen dem Ort des Energieeintrags und dem vom Randbereich abgewandten Bereich des ersten Schweißteils ergibt. Die eingetragene Schweißenergie bleibt somit auf den Randbereich konzentriert.

Gleichzeitig ist der sich an den dünneren Bereich anschließende Energiezuführbereich und/oder der sich an den dünneren Bereich anschließende Materialzuführbereich dicker ausgebildet sein als der betreffende dünnere Bereich des ersten Schweißteils. Diese Struktur kann beispielsweise durch das Vorsehen einer Vertiefung oder Ausnehmung im Randbereich des ersten Schweißteils hergestellt werden. Der Eintrag der Schweißenergie kann dann sowohl auf dem Boden der Ausnehmung als auch im Bereich des dickeren Randes erfolgen. In jedem Fall wirkt der dünnere Bereich als ein den Wärmeenergieabfluss reduzierender Wärmeübergangswiderstand.

Die Struktur zur vorteilhaften Herstellung der Kehlnaht kann am ersten Schweißteil durch einen Kaltverformungsprozess, beispielsweise einen Prägevorgang erzeugt werden. Wird das Schweißteil als Stanzteil hergestellt, so kann der Prägevorgang im selben Arbeitsschritt wie der Stanzvorgang erfolgen, indem das Stanzwerkzeug seiner Abscherkante nachfolgend einen entsprechenden Prägebereich aufweist. Das erste Schweißteil kann auch einen Materialzuführbereich aufweisen, dessen Material vom Material des übrigen ersten Schweißteils verschieden ist. Dieses Material kann beispielsweise eine niedrigere Erweichungs- oder Schmelztemperatur aufweisen oder Stoffe beinhalten, die sich vorteilhaft auf das Bilden der Schweißnaht, sowohl hinsichtlich deren geometrischer Struktur als auch hinsichtlich der Materialzusammensetzung und sonstiger Parameter, wie Festigkeit und dergleichen, auswirken.

Die Erfindung wird nachfolgend anhand in der Zeichnung dargestellter Ausführungsbeispiele näher erläutert. In der Zeichnung zeigen
- Fig. 1: eine schematische Darstellung einer Seitenansicht eines ersten und eines zweiten Schweißteils zur Durchführung eines bekannten Laserschweiß- verfahrens;
- Fig. 2: eine schematische einer Seitenansicht eines ersten Schweißteils mit ge- faster Schweißfläche und eines damit zu verschweißenden zweiten Schweißteils zur Durchführung eines bekannten Laserschweißverfahrens und
- Fig. 3: eine Darstellung ähnlich Fig. 2a, wobei ein erstes Schweißteil nach der Erfindung verwendet ist.

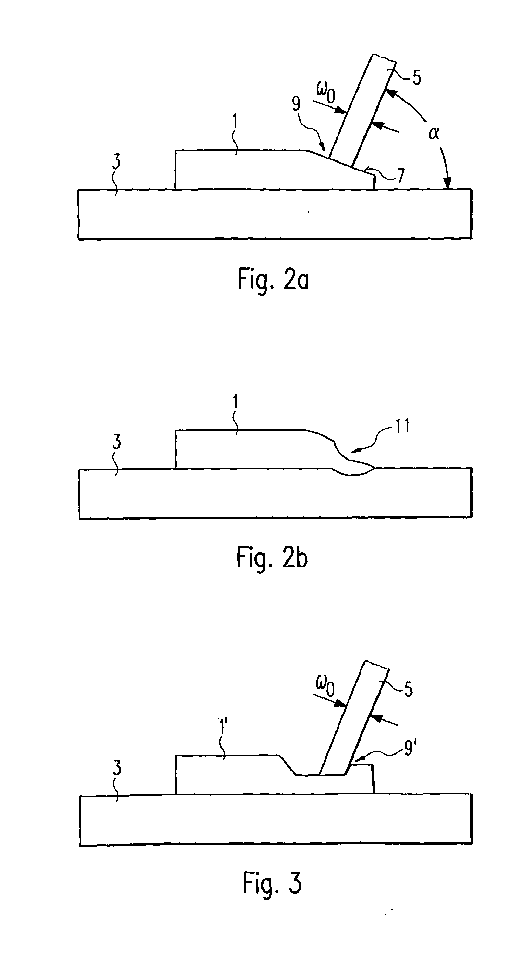

Die Seitenansicht in Fig. 2a zeigt schematisch ein erstes Schweißteil 1, welches mit seiner Unterseite auf der Oberseite eines zweiten Schweißteils 3 aufliegt. Bei dem ersten Schweißteil 1 kann es sich beispielsweise um einen Leiterzug in Form eines Stanzgitters handeln, welches mit einem als Leistungshalbleiterbauelement ausgebildeten zweiten Schweißteil 3 verschweißt werden soll. Die Seitenansicht würde in diesem Fall den Kühlkörper des Leistungshalbleiterbauelements zeigen.

Das Verschweißen kann beispielsweise durch einen Energieeintrag mittels eines Laserstrahls 5 erfolgen, der einen Durchmesser der Fleckweite w₀ aufweist. Der Energieeintrag erfolgt somit, wie in Fig. 2a dargestellt, in einem im Wesentlichen kreisförmigen Fleck des Durchmessers wo. Zur Verbesserung des Schweißvorgangs gegenüber dem bekannten Verfahren weist das erste Schweißteil 1 in seinem Randbereich (rechts in Fig. 2a dargestellt) eine Schräge auf, die sich in Richtung auf den Rand des Schweißteils 1 verjüngt. Diese Schräge 7 stellt eine den Schweißvorgang begünstigende Struktur 9 zur Herstellung einer Kehlnaht zwischen dem ersten Schweißteil 1 und dem zweiten Schweißteil 3 dar.

Wie in Fig. 2a dargestellt, kann die Richtung des Energieeintrags mittels des Laserstrahls 5 senkrecht auf der Schräge 7 stehen. Zur Erzeugung einer Kehlnaht definierter Länge muss selbstverständlich eine Relativbewegung zwischen dem Laserstrahl 5 und dem ersten und zweiten Schweißteil 1, 3 vorgenommen werden. Der Energieeintrag ist selbstverständlich so zu wählen, dass der gesamte Bereich des ersten Schweißteils unterhalb des Energiezuführbereichs (entspricht im dargestellten Ausführungsbeispiel dem Fleck des Laserstrahls 5 auf der Schräge 7) und darüber hinaus ein an diesen Bereich angrenzender Teilbereich des Materials in der Oberfläche des zweiten Schweißteils 3 schmilzt, wobei die aufgeschmolzenen Materialbereiche der beiden Schweißteile 1,3 miteinander verschmelzen und die Kehlnaht 11 bilden. Fig. 2b zeigt, ebenfalls in einer Seitenansicht, die mittels einer Kehlnaht 11 verschweißten Schweißteile 1,3.

Durch das Einbringen der Schweißenergie auf der Oberfläche des ersten Schweißteils 1 in einem Energiezuführbereich, der einen vorbestimmten Abstand vom Rand des ersten Schweißteils 1 aufweist ergibt sich eine geringe Positionierempfindlichkeit der Schweißteile 1, 3 gegenüber der Position des Energieeintrags. Des Weiteren dient der Bereich zwischen dem Energiezuführbereich und dem Rand des ersten Schweißteils als Materialzuführbereich. Der Energieeintrag und die Struktur 9 ist dabei so aufeinander abzustimmen, dass vorzugsweise der gesamte Materialzuführbereich während des Schweißvorgangs aufschmilzt und die Kehlnaht 11 mitbildet. Auf diese Weise erübrigt sich ein möglicherweise erforderliches Zuführen von zusätzlichem Material.

Fig. 3 zeigt eine Struktur 9' im Randbereich des ersten Schweißteils 1'gemäβ der Erfindung Der Randbereich 9' umfasst im Fall des Schweißteils 1' nach Fig. 3 einen Ausnehmung mit schräg nach unten verlaufenden Seitenwandungen auf. Der Energieeintrag mittels eines Laserstrahls 5 kann beispielsweise so erfolgen, dass sich der Spot des Lasers mit der Fleckweite w₀ im Bereich der äußeren Seitenwandung der Ausnehmung befindet. Auf diese Weise wird erreicht, dass im Bereich des Laser-Spots nur relativ wenig Material in der Tiefe des ersten Schweißteils 1' aufgeschmolzen werden muss. Der dünne Boden der Ausnehmung im Randbereich des ersten Schweißteils 1' links vom Laser-Spot, das heißt in Richtung des Inneren des Schweißteils 1', fungiert als relativ großer Wärmeübergangswiderstand hinsichtlich des Wärmeübergangs von der Eintragsstelle der Energie in Richtung auf die dickeren Bereiche (im Inneren) des ersten Schweißteils 1'.

Wie in Fig. 3 dargestellt, kann der Materialzuführbereich, der sich in Fig. 3 rechts an den Energiezuführbereich anschließt, wieder dicker ausgebildet sein. Die Dicke bzw. die Materialmenge des Materialzuführbereichs kann an die speziellen Erfordernisse zur Durchführung des Schweißvorgangs bzw. zur Herstellung der Kehlnaht angepasst werden.

Gleichzeitig ist in Fig. 3 angedeutet, dass der Materialzuführbereich aus einem gegenüber dem Material des übrigen Schweißteils 1' verschiedenen Material bestehen kann. Ein derartiger Materialzuführbereich aus einem unterschiedlichen Material kann beispielsweise durch Aufplattieren oder dergleichen hergestellt werden.

## Patentansprüche

1. Verfahren zum Verschweißen zweier Schweißteile (1,3) unter Herstellung einer Kehlnaht, insbesondere für das Verschweißen des metallischen Kühlkörpers eines empfindlichen Leistungshalbleiterbauelements mit einem Leiterzug,
a) bei dem ein erstes Schweißteil (1) mit einer Auflagefläche zumindest in einem Randbereich einer mittels einer Kehlnaht (11) zu verschweißenden Kante mit einer Auflagefläche eines zweiten Schweißteils (3) in Kontakt gebracht wird,
b) wobei der Randbereich des ersten Schweißteils (1) eine den Schweißvorgang zur Herstellung der Kehlnaht (11) begünstigende Struktur (9) aufweist,
i) welche auf einer der Auflagefläche abgewandten Oberfläche des ersten Schweißteils (1) einen Energiezuführbereich für das Zuführen von Schweißenergie aufweist, und
ii) welche zwischen dem Energiezuführbereich und dem Rand des ersten Schweißteils (1) einen Materialzuführbereich aufweist, der während des Schweißvorgangs aufschmelzbar ist und geschmolzenes Material zur Herstellung der Schweißnaht liefert, und
c) bei dem die Schweißenergie während des Schweißvorgangs ausschließlich einer der Auflagefläche abgewandten Oberfläche des ersten Schweißteils (1) im Energiezuführbereich zugeführt wird,
**dadurch gekennzeichnet,**
d) **dass** der Randbereich im Bereich des Energiezuführbereichs oder in einem in Richtung des inneren Bereichs des Schweißteils (1) dem Energiezuführbereich benachbarten Bereich dünner ausgebildet ist als der innere Bereich des Schweißteils (1), , wobei der dünnere Bereich vom Rand des ersten Schwerβteils (1) einen vorbestimmenin Abstand aufweits,
e) **dass** der sich an den dünneren Bereich anschließende Energiezuführbe reich und/oder der sich an den dünneren Bereich anschließende Materialzuführbereich dicker ausgebildet sind als der dünnere Bereich und dassdas Zuführen der Schweißenergie in einer Richtung erfolgt, deren Richtungskomponente, die senkrecht zum Verlauf der herzustellenden Kehlnaht (11) in Richtung auf einen inneren Bereich des ersten Schweißteils (1) zeigt, mit der Kontaktebene der Auflageflächen des ersten (1) und zweiten (3) Schweißteils einen Schweißwinkel (α) kleiner 90 Grad einschließt,
g) **dass** die Schweißenergie solange zugeführt wird, bis zumindest der Energiezuführbereich des ersten Schweißteils (1) und ein ausreichender, dem Energiezuführbereich des ersten Schweißteils (1) benachbarter Bereich des zweiten Schweißteils (3) und zusätzlich der Materialzuführbereich geschmolzen und miteinander verschmolzen sind.

2. Verfahren nach Anspruch 1, **dadurch gekennzeichnet, dass** das erste Schweißteil (1) ein Leiterzug einer elektrischen Baueinheit ist, welcher mit einem Kühlkörper eines Leistungshalbleiters als zweites Schweißteil (3) verschweißt wird.

3. Verfahren nach Anspruch 1 oder 2, **dadurch gekennzeichnet, dass** die Schweißenergie mittels eines vorzugsweise gepulsten Schweißlasers zugeführt wird.

4. Verfahren nach einem der vorhergehenden Ansprüche, **dadurch gekennzeichnet, dass** der Schweißwinkel (α) in einem Bereich von 50 bis 80 Grad liegt.

## Claims

1. Method for welding two welding parts (1, 3) with the production of a fillet weld, in particular for welding the metallic cooling body of a sensitive power semiconductor component with a printed conductor,
a) in which a first welding part (1) with a bearing surface at least in one edge area of an edge that is to be welded by means of a fillet weld (11) is brought into contact with a bearing surface of a second welding part (3),
b) wherein the edge area of the first welding part (1) has a structure (9) which favours the welding process for the production of the fillet weld (11),
i) which on a surface of the first welding part (1) that is remote from the bearing surface has an energy-supply area for the supply of welding energy, and
ii) which between the energy-supply area and the edge of the first welding part (1) has a material-supply area which can be melted down during the welding process and delivers molten material for the production of the welding seam, and
c) in which the welding energy is supplied in the energy-supply area during the welding process exclusively to a surface of the first welding part (1) that is remote from the bearing surface,
**characterised in that**
d) the edge area in the area of the energy-supply area or in an area that is adjacent to the energy-supply area in the direction of the inner area of the welding part (1) is formed so as to be thinner than the inner area of the welding part (1), wherein the thinner area is at a predetermined distance from the edge of the first welding part (1),
e) the energy-supply area that follows on from the thinner area and/or the material-supply area that follows on from the thinner area are/is formed so as to be thicker than the thinner area, and
f) the supply of welding energy is effected in a direction of which the direction component, pointing perpendicularly with respect to the course of the fillet weld (11) to be produced in the direction of an inner area of the first welding part (1), encloses a welding angle (α) smaller than 90 degrees with the contact plane of the bearing surfaces of the first welding part (1) and the second welding part (3),
g) the welding energy is supplied for so long until at least the energy-supply area of the first welding part (1) and a sufficient area of the second welding part (3) that is adjacent to the energy-supply area of the first welding part (1) and in addition the material-supply area have melted and fused together.

2. Method according to claim 1, **characterised in that** the first welding part (1) is a printed conductor of an electrical structural unit which is welded with a cooling body of a power semiconductor as a second welding part (3).

3. Method according to claim 1 or 2, **characterised in that** the welding energy is supplied by means of a welding laser which is preferably pulsed.

4. Method according to one of the preceding claims, **characterised in that** the welding angle (α) lies in a range from 50 to 80 degrees.

## Revendications

1. Procédé pour le soudage de deux pièces à souder (1, 3) en réalisant une soudure d'angle, en particulier pour réaliser une soudure entre le dissipateur thermique métallique d'un composant de semi-conducteur de puissance sensible et un chemin conducteur,
a) dans lequel une première pièce à souder (1) ayant une surface d'appui est mis en contact avec une surface d'appui d'une seconde pièce à souder (3) dans au moins une zone marginale du bord à souder moyennant une soudure d'angle,
b) dans lequel la zone marginale de la première pièce à souder (1) présente une structure (9) favorable à l'opération de soudage pour la réalisation de la soudure d'angle (11),
i) laquelle structure présente, sur une surface de la première pièce à souder (1) opposée à la surface d'appui, une zone d'alimentation en énergie destinée à l'alimentation en énergie de soudage, et
ii) laquelle structure présente, entre la zone d'alimentation en énergie et le bord de la première pièce à souder (1), une zone d'apport de matériau qui est fusible au cours de l'opération de soudage et fournit du matériau fondu pour la réalisation du cordon de soudure, et
c) dans lequel l'énergie de soudage est conduite, au cours de l'opération de soudage, exclusivement vers une surface de la première pièce à souder (1) qui est opposée à la surface d'appui, dans la zone d'alimentation en énergie, **caractérisé en ce que**
d) la zone marginale située dans la région de la zone d'alimentation en énergie ou située, en direction vers la zone interne de la pièce à souder (1), dans une région voisine de la zone d'alimentation en énergie présente une forme plus mince que la zone interne de la pièce à souder (1), la zone plus mince se situant à une distance prédéterminée par rapport au bord de la première pièce à souder (1),
e) la zone d'alimentation en énergie adjacente à la zone plus mince et/ou la zone d'apport de matériau adjacente à la zone plus mince présentent une forme plus épaisse que la zone plus mince,
f) l'alimentation en énergie de soudage est dirigée dans un sens dont la composante directionnelle qui, perpendiculairement au tracé de la soudure d'angle (11) à réaliser, pointe vers une zone interne de la première pièce à souder (1), forme avec le plan de contact des surfaces d'appui de la première (1) et de la seconde pièce à souder (2) un angle de soudage (α) inférieur à 90 degrés, et
g) l'énergie de soudage est acheminée jusqu'à ce qu'au moins la zone d'alimentation en énergie de la première pièce à souder (1) et une zone suffisante de la seconde pièce à souder (3) avoisinant la zone d'alimentation en énergie de la première pièce à souder (1) et, de plus, la zone d'apport de matériau soient fondues et fusionnées les unes avec les autres.

2. Procédé selon la revendication 1, **caractérisé en ce que** la première pièce à souder (1) est un chemin conducteur d'un composant électrique, lequel on soude à un dissipateur thermique d'un semi-conducteur de puissance comme seconde pièce à souder (3).

3. Procédé selon la revendication 1 ou 2, **caractérisé en ce que** l'énergie de soudage est acheminée au moyen d'un laser de soudage, de préférence pulsé.

4. Procédé selon l'une quelconque des revendications précédentes, **caractérisé en ce que** l'angle de soudage (α) est de 50 à 80 degrés.
